# EUROPEAN PATENT APPLICATION

(11) **EP 4 607 325 A1**
(43) Date of publication of application: **27.08.2025**
(21) Application number: 24215682.6
(22) Date of filing: 27.11.2024
(51) Int. Cl.: G06F 3/041, G06F 3/044

(54) **DISPLAY DEVICE**

(30) Priority: 22.02.2024 KR 20240025786
(71) Applicant: LG Display Co., Ltd., Seoul 07336 (KR)
(72) Inventor: SUCHANG, An, 10845 Paju-si (KR); JIHYUN, Jung, 10845 Paju-si (KR); JAEGYUN, Lee, 10845 Paju-si (KR); RUDA, Rhe, 10845 Paju-si (KR); HYANGMYOUNG, Gwon, 10845 Paju-si (KR)
(74) Representative: Cousens, Nico

(57) **Abstract**

Embodiments of the present disclosure relate to a display device. A display device may include a planarization layer disposed on a substrate, a bank disposed on the planarization layer, a first encapsulation layer disposed on the bank, a first bridge metal disposed on the first encapsulation layer, a lower touch routing line disposed in a dam area, a touch interlayer insulating film disposed on the first bridge metal and the lower touch routing line, and a second encapsulation layer disposed on the inner side of the touch interlayer insulating film disposed in the dam area, thereby protecting the touch routing line while preventing the organic film from overflowing.

## Description

This application claims priority from Korean Patent Application No. 10-2024-0025786, filed on February 22, 2024.

### BACKGROUND

### Technical Field

Embodiments of the present disclosure relate to a display device.

### Description of the Related Art

As the information society develops, there is increasing the demand for display devices for displaying images in various forms. Therefore, in recent years, there have been used various display devices such as liquid crystal displays and organic light emitting display devices.

A display device may include a display area and a non-display area. The non-display area may be also referred to as a bezel.

A dam may be disposed in the non-display area. The dam may prevent an organic film from overflowing outside the area where the organic film is to be formed during forming the organic film.

### BRIEF SUMMARY

Embodiments of the present disclosure may provide a display device including an outer dam capable of preventing an organic film from overflowing.

Embodiments of the present disclosure may provide a display device including an outer dam capable of protecting a touch routing line.

Embodiments of the present disclosure may provide a display device with improved process efficiency by an outer dam protecting a touch routing line.

A display device according to embodiments of the present disclosure may include a substrate including a display area, a dam area, and a pad area, a planarization layer disposed on the substrate, a bank disposed on the planarization layer, a first encapsulation layer disposed on the bank, a first bridge metal disposed on the first encapsulation layer, a lower touch routing line disposed on the first encapsulation layer and extending to the dam area, a touch interlayer insulating film disposed on the first bridge metal and the lower touch routing line, a touch sensor metal electrically connected to the first bridge metal and disposed on the touch interlayer insulating film, and a second encapsulation layer disposed on the touch sensor metal and disposed on the inner side of the touch interlayer insulating film disposed in the dam area.

The display device according to embodiments of the present disclosure may further include an outer dam disposed in the dam area. In this case, the outer dam may include the lower touch routing line, a touch buffer film covering the lower touch routing line in the dam area, and the touch interlayer insulating film covering the touch buffer film in the dam area.

The touch interlayer insulating film included in the outer dam may have a thickness of the upper surface greater than a thickness of the side surface.

The outer dam may include a first outer dam disposed on the outer side of the second encapsulation layer, and a second outer dam disposed on the outer side of the first outer dam.

The side surface of the outer dam may be disposed in contact with the second encapsulation layer.

The second encapsulation layer may be an organic insulating film. The second encapsulation layer may include one of an acrylic resin, an epoxy resin, a polyimide, polyethylene, or a silicon oxycarbon.

The second encapsulation layer may be formed through an inkjet process.

According to embodiments of the present disclosure, it is possible to provide a display device including an outer dam capable of preventing an organic film from overflowing.

According to embodiments of the present disclosure, it is possible to provide a display device including an outer dam capable of protecting a touch routing line.

According to embodiments of the present disclosure, it is possible to provide a display device with improved process efficiency by an outer dam protecting a touch routing line.

### BRIEF DESCRIPTION OF THE SEVERAL VIEWS OF THE DRAWINGS

FIG. 1 is a system configuration diagram of a display device according to embodiments of the present disclosure.
FIG. 2 illustrates a display panel according to embodiments of the present disclosure.
FIG. 3 illustrates a substrate of a display panel according to embodiments of the present disclosure.
FIG. 4 is a cross-sectional view of a display area of a display panel according to embodiments of the present disclosure.
FIG. 5 is a diagram related to a configuration for touch sensing according to embodiments of the present disclosure.
FIG. 6 is a cross-sectional view of an outer dam as a protective layer according to embodiments of the present disclosure.
FIG. 7 is a cross-sectional view of an outer dam including an upper touch routing line according to embodiments of the present disclosure.
FIG. 8 is a cross-sectional view of an outer dam including a touch interlayer insulating film according to embodiments of the present disclosure.

### DETAILED DESCRIPTION

In the following description of examples or embodiments of the present disclosure, reference will be made to the accompanying drawings in which it is shown by way of illustration specific examples or embodiments that can be implemented, and in which the same reference numerals and signs can be used to designate the same or like components even when they are shown in different accompanying drawings from one another.

The shapes, sizes, dimensions (e.g., length, width, height, thickness, radius, diameter, area, etc.), ratios, angles, number of elements, and the like illustrated in the accompanying drawings for describing the embodiments of the present disclosure are merely examples, and the present disclosure is not limited thereto.

A dimension including size and a thickness of each component illustrated in the drawing are illustrated for convenience of description, and the present disclosure is not limited to the size and the thickness of the component illustrated, but it is to be noted that the relative dimensions including the relative size, location, and thickness of the components illustrated in various drawings submitted herewith are part of the present disclosure.

Further, in the following description of examples or embodiments of the present disclosure, detailed descriptions of well-known functions and components incorporated herein will be omitted when it is determined that the description may make the subject matter in some embodiments of the present disclosure rather unclear. The terms such as "including," "having," "containing," "constituting" "make up of," and "formed of" used herein are generally intended to allow other components to be added unless the terms are used with the term "only." As used herein, singular forms are intended to include plural forms unless the context clearly indicates otherwise.

Terms, such as "first," "second," "A," "B," "(A)," or "(B)" may be used herein to describe elements of the present disclosure. Each of these terms is not used to define essence, order, sequence, or number of elements, etc., but is used merely to distinguish the corresponding element from other elements.

When it is mentioned that a first element "is connected or coupled to," "contacts or overlaps," etc., a second element, it should be interpreted that, not only can the first element "be directly connected or coupled to" or "directly contact or overlap" the second element, but a third element can also be "interposed" between the first and second elements, or the first and second elements can "be connected or coupled to," "contact or overlap," etc., each other via a fourth element. Here, the second element may be included in at least one of two or more elements that "are connected or coupled to," "contact or overlap," etc., each other.

When time relative terms, such as "after," "subsequent to," "next," "before," and the like, are used to describe processes or operations of elements or configurations, or flows or steps in operating, processing, manufacturing methods, these terms may be used to describe non-consecutive or non-sequential processes or operations unless the term "directly" or "immediately" is used together.

In addition, when any dimensions, relative sizes, etc., are mentioned, it should be considered that numerical values for an elements or features, or corresponding information (e.g., level, range, etc.) include a tolerance or error range that may be caused by various factors (e.g., process factors, internal or external impact, noise, etc.) even when a relevant description is not specified. Further, the term "may" fully encompasses all the meanings of the term "can".

Hereinafter, various embodiments of the disclosure are described in detail with reference to the accompanying drawings.

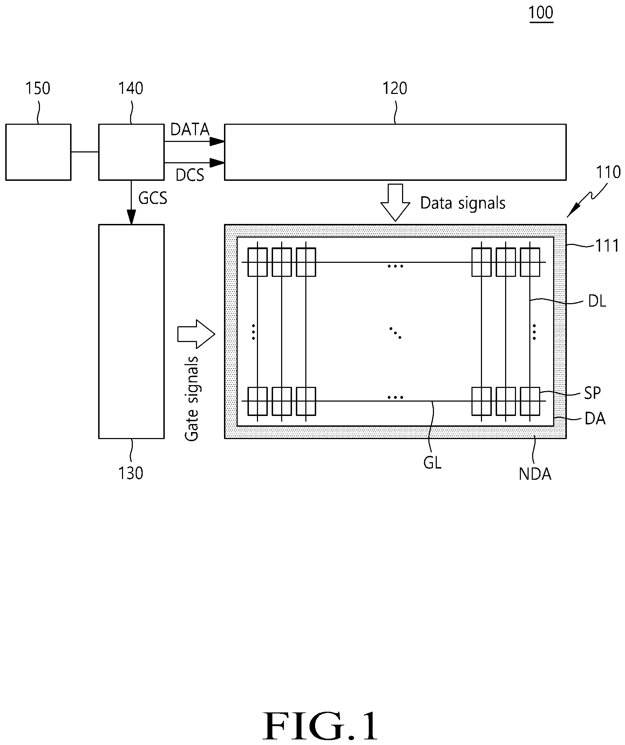

FIG. 1 is a system configuration diagram of a display device 100 according to embodiments of the present disclosure.

Referring to FIG. 1, a display device 100 according to embodiments of the present disclosure may include a display panel 110 and a display driving circuit as components for displaying an image. The display driving circuit is a circuit for driving the display panel 110, and may include a data driving circuit 120, a gate driving circuit 130, and a display controller 140.

The display panel 110 may include a substrate 111 and a plurality of subpixels SP disposed on the substrate 111.

The substrate 111 of the display panel 110 may include a display area DA capable of displaying an image and a non-display area NDA located outside the display area DA.

A plurality of subpixels SP for image display may be disposed in the display area DA, and the non-display area NDA may include a pad area PA located in the first direction from the display area DA.

In a display panel 110 according to embodiments of the present disclosure, the non-display area NDA may be very small. In this specification, the non-display area NDA may be also referred to as a "bezel."

For example, the non-display area NDA may include a first non-display area located outside the display area DA in a first direction, a second non-display area located outside the display area DA in a second direction intersecting the first direction, a third non-display area located outside the display area DA in the opposite direction to the first direction, and a fourth non-display area located outside the display area DA in the direction opposite to the second direction. One or both of the first to fourth non-display areas may include a pad area to which the data driving circuit 120 is connected or bonded. Among the first to fourth non-display areas, two or three which do not include the pad area may be very small in size.

For another example, a boundary area between the display area DA and the non-display area NDA may be bent so that the non-display area NDA may be located below the display area. In this case, when the user looks at the display device 100 from the front, there may be little or no non-display area NDA visible to the user.

Various types of signal lines for driving a plurality of subpixels SP may be disposed on the substrate 111 of the display panel 110.

The display device 100 according to embodiments of the present disclosure may be a liquid crystal display device or the like, or may be a self-luminous display device in which the display panel 110 emits light by itself. When the display device 100 according to embodiments of the present disclosure is a self-luminous display device, each of the plurality of subpixels SP may include a light emitting device.

For example, the display device 100 according to embodiments of the present disclosure may be an organic light emitting display device in which a light emitting device is implemented as an organic light emitting diode (OLED). For another example, the display device 100 according to embodiments of the present disclosure may be an inorganic light emitting display device in which the light emitting device is implemented as an inorganic-based light emitting diode. For another example, the display device 100 according to embodiments of the present disclosure may be a quantum dot display device in which a light emitting device is implemented with quantum dots, which are semiconductor crystals emitting light by itself.

The structure of each of the plurality of subpixels SP may vary depending on the type of the display device 100. For example, if the display device 100 is a self-luminous display device with the subpixel SP emitting light by itself, each subpixel SP may include a self-luminous light emitting device, one or more transistors, and one or more capacitors.

For example, various types of signal lines may include a plurality of data lines DL supplying data signals (also called data voltages or image signals) and a plurality of gate lines GL for transmitting gate signals (also called scan signals).

For example, the plurality of data lines DL and the plurality of gate lines GL may cross each other. Each of the plurality of data lines DL may be arranged to extend in a first direction. Each of the plurality of gate lines GL may be arranged to extend in a second direction. Here, the first direction may be a column direction and the second direction may be a row direction. Alternatively, the first direction may be a row direction and the second direction may be a column direction. Hereinafter, for convenience of explanation, it will exemplified a case in which each of the plurality of data lines DL is arranged in a column direction, and each of the plurality of gate lines GL is arranged in a row direction.

The data driving circuit 120 is a circuit for driving a plurality of data lines DL, and may output data signals to the plurality of data lines DL.

The data driving circuit 120 may receive image data in digital form from the display controller 140 and convert the received image data into analog data signals to output to a plurality of data lines DL.

For example, the data driving circuit 120 may be connected to the display panel 110 using a tape automated bonding (TAB) method, or may be connected to the bonding pad of the display panel 110 using a chip-on-glass (COG) or chip-on-panel (COP) method, or may be implemented using a chip-on-film (COF) method and connected to the display panel 110.

The data driving circuit 120 may be connected to one side *(e.g.,* the upper or lower side) of the display panel 110. Depending on the driving method, panel design method, etc., the data driving circuit 120 may be connected to both sides (e.g., upper and lower sides) of the display panel 110, or may be connected to two or more of the four sides of the display panel 110.

The data driving circuit 120 may be connected to the outside of the display area DA of the display panel 110, but alternatively, it may be disposed in the display area DA of the display panel 110.

The gate driving circuit 130 is a circuit for driving a plurality of gate lines GL, and may output gate signals to the plurality of gate lines GL.

The gate driving circuit 130 may receive a first gate voltage corresponding to the turn-on level voltage and a second gate voltage corresponding to the turn-off level voltage along with various gate driving control signals GCS, and may generate gate signals and supply the generated gate signals to the plurality of gate lines GL.

In the display device 100 according to embodiments of the present disclosure, the gate driving circuit 130 may be built into the display panel 110 as a gate-in-panel (GIP) type. If the gate driving circuit 130 is a gate-in-panel type, the gate driving circuit 130 may be formed on a substrate of the display panel 110 during the manufacturing process of the display panel 110.

In the display device 100 according to embodiments of the present disclosure, the gate driving circuit 130 may be disposed in the display area DA of the display panel 110. For example, the gate driving circuit 130 may be disposed in a first partial area within the display area DA *(e.g.,* a left area or a right area within the display area DA). For another example, the gate driving circuit 130 may be disposed in a first partial area within the display area DA *(e.g.,* a left area or a right area within the display area DA) and a second partial area *(e.g.,* a right area or a left area within the display area DA).

In the present disclosure, a gate driving circuit 130 built into the display panel 110 as a gate-in-panel type may be referred to as a "gate-in-panel circuit."

The display controller 140 may be a device for controlling the data driving circuit 120 and the gate driving circuit 130, and may control the driving timing for the plurality of data lines DL and the driving timing of the plurality of gate lines GL.

The display controller 140 may supply a data driving control signal DCS to the data driving circuit 120 to control the data driving circuit 120, and may supply a gate driving control signal GCS to the gate driving circuit 130 to control the gate driving circuit 130.

The display controller 140 may receive input image data from a host system 150 and supply image data DATA to the data driving circuit 120 based on the input image data.

The display controller 140 may be implemented as a separate component from the data driving circuit 120, or may be integrated with the data driving circuit 120 and implemented as an integrated circuit.

The display controller 140 may be a timing controller used in typical display technology, or may be a control device capable of further performing other control functions including a timing controller, or may be a control device different from the timing controller, or may be a control device other than a timing controller, or may be a circuit within the control device. The display controller 140 may be implemented with various circuits or electronic components, such as an integrated circuit (IC), a field programmable gate array (FPGA), an application specific integrated circuit (ASIC), or Processor.

The display controller 140 may be mounted on a printed circuit board, a flexible printed circuit, etc., and may be electrically connected to the data driving circuit 120 and the gate driving circuit 130 through a printed circuit board, a flexible printed circuit.

The display controller 240 may transmit and receive signals with the data driving circuit 120 according to one or more predetermined interfaces. For example, the interface may include a low voltage differential signaling (LVDS) interface, an embedded clock point-point interface (EPI) interface, or a serial peripheral interface (SPI).

In order to provide not only an image display function but also a touch sensing function, the display device 100 according to embodiments of the present disclosure may include a touch sensor and a touch sensing circuit for detecting an occurrence of a touch by a touch object such as a finger or pen or detection a touch position by sensing the touch sensor.

The touch sensing circuit may include a touch driving circuit for driving and sensing a touch sensor to generate and output touch sensing data, and a touch controller for detecting the occurrence of a touch or detecting the touch position using touch sensing data.

The touch sensor may include a plurality of touch electrodes. The touch sensor may further include a plurality of touch lines to electrically connect a plurality of touch electrodes and the touch driving circuit.

The touch sensor may exist outside the display panel 110 in the form of a touch panel or may exist inside the display panel 110. If the touch sensor exists outside the display panel 110 in the form of a touch panel, the touch sensor may be referred to as an external type. If the touch sensor is an external type, the touch panel and the display panel 110 may be manufactured separately and combined during the assembly process. The external touch panel may include a touch panel substrate and a plurality of touch electrodes on the touch panel substrate.

If the touch sensor exists inside the display panel 110, the touch sensor may be formed on the substrate along with signal lines and electrodes related to display driving during the manufacturing process of the display panel 110.

The touch driving circuit may supply a touch driving signal to at least one of the plurality of touch electrodes and generate touch sensing data by sensing at least one of the plurality of touch electrodes.

The touch sensing circuit may perform touch sensing using a self-capacitance sensing method or a mutual-capacitance sensing method.

If the touch sensing circuit performs touch sensing using a self-capacitance sensing method, the touch sensing circuit may perform touch sensing based on the capacitance between each touch electrode and a touch object (e.g., finger, pen, etc.). According to the self-capacitance sensing method, each of the plurality of touch electrodes may serve as a driving touch electrode and a sensing touch electrode. The touch driving circuit 260 may drive all or part of the plurality of touch electrodes and sense all or part of the plurality of touch electrodes.

If the touch sensing circuit performs touch sensing using the mutual-capacitance sensing method, the touch sensing circuit may perform touch sensing based on the capacitance between touch electrodes. According to the mutual-capacitance sensing method, the plurality of touch electrodes may be divided into driving touch electrodes and sensing touch electrodes. The touch driving circuit may drive driving touch electrodes and sense sensing touch electrodes.

The touch driving circuit and the touch controller included in the touch sensing circuit may be implemented as separate devices or as one device. Additionally, the touch driving circuit and the data driving circuit may be implemented as separate devices or as one device.

The display device 100 may further include a power supply circuit which supplies various types of power to the display driving circuit and/or the touch sensing circuit.

The display device 100 according to embodiments of the present disclosure may be a mobile terminal such as a smart phone or tablet, or a monitor or television of various sizes, but is not limited thereto, and may be a display of various types and sizes capable of displaying information or images.

The display device 100 according to embodiments of the present disclosure may further include an electronic device such as a camera (e.g., image sensor) and a detection sensor. For example, the detection sensor may be a sensor for detecting an object or a human body by receiving light such as infrared, ultrasonic, or ultraviolet rays.

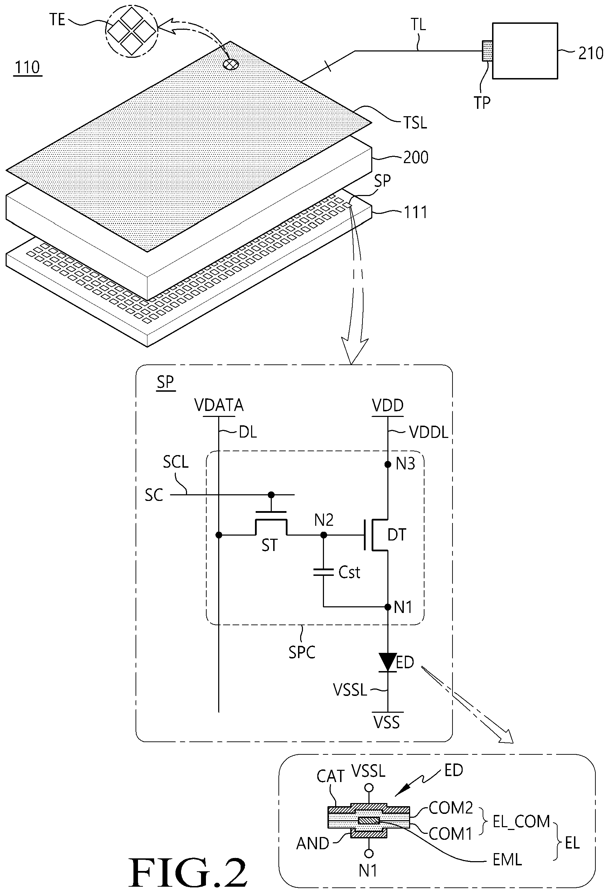

FIG. 2 illustrates a display panel 110 according to embodiments of the present disclosure.

Referring to FIG. 2, the display panel 110 may include a substrate 111 disposed in a plurality of subpixels SP and an encapsulation layer 200 on the substrate 111. Here, the encapsulation layer 200 may also be referred to as an encapsulation substrate or an encapsulation portion.

Referring to FIG. 2, when the display device 100 according to embodiments of the present disclosure is a self-luminous display device, each of the plurality of subpixels SP may include a light emitting device ED and a subpixel circuit SPC for driving the light emitting device ED.

Referring to FIG. 2, the subpixel circuit SPC may include a plurality of pixel driving transistors and at least one capacitor for driving the light emitting device ED. In the present disclosure, the subpixel circuit SPC may drive the light emitting device ED by supplying a driving current to the light emitting device ED at a predetermined timing. The light emitting device ED may be driven by a driving current and emit light.

The plurality of pixel driving transistors may include a driving transistor DT for driving the light emitting device ED, and a scan transistor ST which is turned on or off depending on the scan signal SC.

The driving transistor DT may supply driving current to the light emitting device ED.

The scan transistor ST may be configured to control the electrical state of a corresponding node in the subpixel circuit SPC or to control the state or operation of the driving transistor DT.

At least one capacitor may include a storage capacitor Cst to maintain a constant voltage during the frame.

In order to drive the subpixel SP, a data signal VDATA which is an image signal, and a scan signal SC which is a gate signal may be applied to the subpixel SP. In addition, a common pixel driving voltage including a first driving voltage VDD and a second driving voltage VSS may be applied to the subpixel SP in order to drive the subpixel SP.

The light emitting device ED may include an anode AND, a light emitting device intermediate layer EL, and a cathode CAT. The light emitting device intermediate layer EL may be a layer disposed between the anode AND and the cathode CAT.

In the case that the light emitting device ED is an organic light emitting device, the light emitting device intermediate layer EL may include an emission layer EML, a first common intermediate layer COM1 between the anode AND and the emission layer EML, and a second common intermediate layer COM2 between the emission layer EML and the cathode. The emission layer EML may be disposed in each subpixel SP. In comparison, the first common intermediate layer COM1 and the second common intermediate layer COM2 may be commonly disposed across a plurality of subpixels SP. The emission layer EML may be disposed in each emission area, and the first common intermediate layer COM1 and the second common intermediate layer COM2 may be commonly disposed across a plurality of emission areas and non-emission areas. The first common intermediate layer COM1 and the second common intermediate layer COM2 may be collectively referred to as a common intermediate layer EL_COM.

For example, the first common intermediate layer COM1 may include a hole injection layer HIL and a hole transport layer HTL. The second common intermediate layer COM2 may include an electron transport layer ETL and an electron injection layer EIL. The hole injection layer may inject holes from the anode AND to the hole transport layer, the hole transport layer may transport holes to the emission EML, the electron injection layer may inject electrons from the cathode CAT to the electron transport layer, and the electron transport layer may transport electrons to the emission layer EML.

For example, the cathode CAT may be electrically connected to a second common driving voltage line VSSL. A second common driving voltage VSS, which is a type of common pixel driving voltage, may be applied to the cathode CAT through the second common driving voltage line VSSL. The anode AND may be electrically connected to a first node N1 of the driving transistor DT of each subpixel SP. In the present disclosure, the second common driving voltage VSS may also be referred to as a base voltage VSS, and the second common driving voltage line VSSL may also be referred to as a base voltage line VSSL.

For example, the anode AND may be a pixel electrode disposed in each subpixel SP, and the cathode CAT may be a common electrode commonly disposed in a plurality of subpixels SP. For another example, the cathode CAT may be a pixel electrode disposed in each subpixel SP, and the anode AND may be a common electrode commonly disposed in a plurality of subpixels SP. Hereinafter, for convenience of explanation, it is assumed that the anode AND is a pixel electrode and the cathode CAT is a common electrode.

Each light emitting device ED may be composed of overlapping parts of an anode AND, a light emitting device intermediate layer EL and a cathode CAT. A predetermined emission area may be formed by each light emitting device ED. For example, the emission area of each light emitting device ED may include an area where the anode AND, the light emitting device intermediate layer EL and the cathode CAT overlap.

For example, the light emitting device ED may be an organic light emitting diode (OLED), an inorganic light emitting diode, or a quantum dot light emitting device. For example, in the case that the light emitting device ED is an organic light emitting diode OLED, the light emitting device intermediate layer EL in the light emitting device ED may include an organic light emitting device intermediate layer EL containing an organic material.

The driving transistor DT may be a driving transistor for supplying driving current to the light emitting device ED. The driving transistor DT may be connected between a first common driving voltage line VDDL and the light emitting device ED.

The driving transistor DT may include a first node N1 electrically connected to the light emitting device ED, a second node N2 to which the data signal VDATA is applied, and a third node N3 to which the driving voltage VDD is applied from the driving voltage line DVL.

In the driving transistor DT, the second node N2 may be a gate node, the first node N1 may be a source node or a drain node, and the third node N3 may be a drain node or a source node. Hereinafter, for convenience of explanation, it will be described a case in which the second node N2 is a gate node, the first node N1 is a source node, and the third node N3 is a drain node in the driving transistor DT.

The scan transistor ST included in the subpixel circuit SPC illustrated in FIG. 2 may be a switching transistor for transmitting a data signal VDATA, which is an image signal, to the second node N2 which is the gate node of the driving transistor DT.

The scan transistor ST may be controlled on-off by the scan signal SC which is a gate signal applied through the scan line SCL as a type of gate line GL, and may control the electrical connection between the second node N2 of the driving transistor DT and the data line DL. The drain electrode or source electrode of the scan transistor ST may be electrically connected to the data line DL, and the source electrode or drain electrode of the scan transistor ST may be electrically connected to the second node N2 of the driving transistor DT. The gate electrode of the scan transistor ST may be electrically connected to the scan line SCL.

The storage capacitor Cst may be electrically connected between the first node N1 and the first node N2 of the driving transistor DT. The storage capacitor Cst may include a first capacitor electrode electrically connected to the first node N1 of the driving transistor DT or corresponding to the first node N1 of the driving transistor DT, and a second capacitor electrode electrically connected to the second node N2 of the driving transistor DT or corresponding to the second node N2 of the driving transistor DT.

The storage capacitor Cst may be an external capacitor intentionally designed outside the driving transistor DT rather than a parasitic capacitor (e.g., Cgs, Cgd) as an internal capacitor which may exist between the first node N1 and the second node N2 of the driving transistor DT.

Each of the driving transistor DT and the scan transistor ST may be an n-type transistor or a p-type transistor.

The display panel 110 may have a top emission structure or a bottom emission structure.

If the display panel 110 has a top emission structure, at least a portion of the subpixel circuit SPC may overlap with at least a portion of the light emitting device ED in the vertical direction. Alternatively, if the display panel 110 has a bottom emission structure, the subpixel circuit SPC may not overlap with the light emitting device ED in the vertical direction.

As shown in FIG. 2, the subpixel circuit SPC may have 2T-1C structure including two transistors T1 and T2 and one capacitor Cst. In some case, the subpixel circuit SPC may further include one or more transistors or one or more capacitors.

For example, the subpixel circuit SPC may have a 8T-1C structure including eight transistors and a single capacitor. For another example, the subpixel circuit SPC may have a 6T-2C structure including six transistors and two capacitors. For another example, the subpixel circuit SPC may have a 7T-1C structure including seven transistors and one capacitor.

Depending on the structure of the subpixel circuit SPC, there may vary the type and number of gate signal and/or gate lines supplied to the subpixel SP.

In addition, depending on the structure of the subpixel circuit SPC, there may vary the type and number of common pixel driving voltages supplied to the subpixel SP.

Since circuit elements within each subpixel SP (in particular, light emitting devices EDs implemented with organic light emitting diodes (OLEDs) containing organic materials) are vulnerable to external moisture or oxygen, an encapsulation layer 200 may be disposed on the display panel 110 to prevent oxygen from penetrating into the circuit elements (particularly, the light emitting device ED). The encapsulation layer 200 may be configured in various shapes to prevent the light emitting device ED from coming into contact with moisture or oxygen.

Referring to FIG. 2, the display device 100 according to the embodiments of the present disclosure may further include a touch sensor layer TSL including a plurality of sensor electrodes to sense a touch of an user, and a touch sensing circuit 210 configured to sense the plurality of sensor electrodes to determine the presence or absence of a touch or touch coordinates.

The touch sensor layer TSL may be built or embedded into the display panel 110. For example, the touch sensor layer TSL may be disposed on an encapsulation layer 200 within the display panel 110.

The display panel 110 may not only include the touch sensor layer TSL, but may also include a plurality of touch pads to which the touch sensing circuit 210 is electrically connected, and a plurality of touch routing lines TL for electrically connecting the plurality of sensor electrodes included in the touch sensor layer TSL and the plurality of touch pads connected to the touch sensing circuit 210.

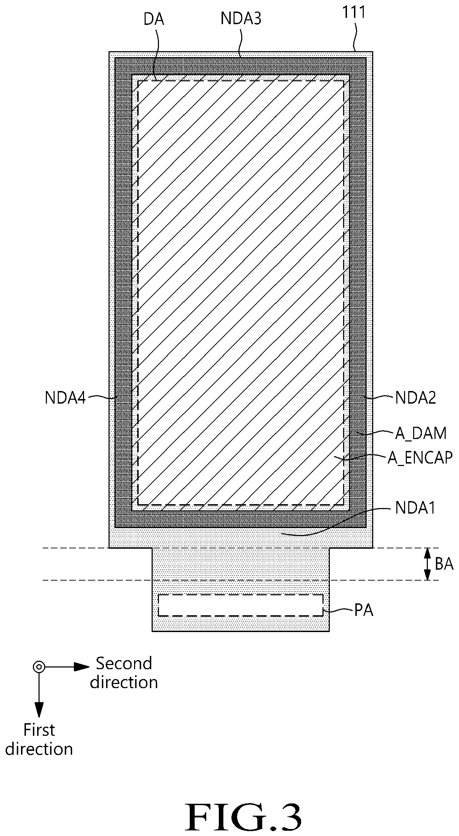

FIG. 3 illustrates a substrate 111 of a display panel 110 according to embodiments of the present disclosure.

Referring to FIG. 3, the substrate 111 of the display panel 110 according to the embodiments of the present disclosure may include a display area DA on which an image may be displayed and a non-display area NDA on which an image is not displayed.

Referring to FIG. 3, the non-display area NDA may include a first non-display area NDA1 located in a first direction from the display area DA, a second non-display area NDA2 located in a second direction from the display area DA, a third non-display area NDA3 located in a direction opposite to the first direction from the display area DA, and a fourth non-display area NDA4 located in a direction opposite to the second direction from the display area DA. For example, the first direction may be a column direction (e.g., Y-axis direction), and the second direction intersecting the first direction may be a row direction (e.g., X-axis direction).

Referring to FIG. 3, the first non-display area NDA1 may include a pad area PA in which a plurality of pads are disposed.

In the pad area PA, there may be disposed a plurality of pads to which a driving circuit is electrically connected. A plurality of driving circuits or printed circuit boards may be electrically connected. For example, the plurality of pads may include a plurality of display pads and a plurality of touch pads. A plurality of data lines, a first common driving voltage line VDDL, and a second common driving voltage line VSSL may be electrically connected to the plurality of display pads. A plurality of touch routing lines TL may be electrically connected to the plurality of touch pads.

Referring to FIG. 3, the first non-display area NDA1 may further include a bending area BA. In this case, the substrate 111 may be a flexible substrate. In some cases, the first non-display area NDA1 may not include a bending area BA.

Referring to FIG. 3, the display panel 110 may further include a ground line disposed in a non-display area NDA of the substrate 111. The ground line may be disposed from one point of the pad area PA to another point of the pad area PA via the second non-display area NDA2, the third non-display area NDA3 and the fourth non-display area NDA4.

Referring to FIG. 3, the display panel 110 may include an encapsulation layer area A_ENCAP and a dam area A_DAM.

Referring to FIG. 3, the encapsulation layer area A_ENCAP may be an area where the encapsulation layer 200 is disposed. In the display panel 110 according to the embodiments of the present disclosure, the encapsulation layer 200 may have a structure in which an inorganic film and an organic film are laminated. In this case, an edge of the encapsulation layer 200 may be considered as an edge of the organic film.

Referring to FIG. 3, the dam area A_DAM may be an area surrounding the encapsulation layer area A_ENCAP. A structure serving as a dam may be located in the dam area A_DAM. The dam may prevent the organic film in a liquid state from flowing out to the outside.

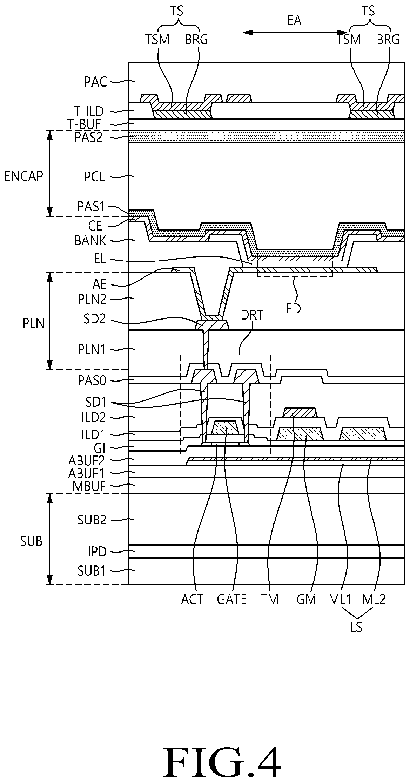

FIG. 4 is a cross-sectional view of the display area DA of the display panel 110 according to the embodiments of the present disclosure.

Referring to FIG. 4, the substrate SUB may include a first substrate SUB1, an interlayer insulating film IPD, and a second substrate SUB2. The interlayer insulating film IPD may be located between the first substrate SUB1 and the second substrate SUB2. The substrate SUB may be configured to include the first substrate SUB1, the interlayer insulating film IPD and the second substrate SUB2, thereby preventing moisture penetration. For example, the first substrate SUB1 and the second substrate SUB2 may be polyimide PI substrates. The first substrate SUB1 may be referred to as a primary PI substrate, and the second substrate SUB2 may be referred to as a secondary PI substrate.

Referring to FIG. 4, there may be disposed various patterns (e.g., ACT, SD1, GATE1), various insulating films or insulating layers (e.g., MBUF, ABUF1, ABUF2, GI, ILD1, ILD2, PAS0), and various metal patterns (e.g., TM, GM, ML1, ML2) for forming transistors such as driving transistors DRT on the substrate SUB.

Referring to FIG. 4, a multi-buffer layer MBUF may be disposed on the second substrate SUB2, and a first active buffer layer ABLTF1 may be disposed on the multi-buffer layer MBUF.

A first metal layer ML1 and a second metal layer ML2 may be disposed on the first active buffer layer ABUF1. Here, the first metal layer ML1 and the second metal layer ML2 may be a light shielding layer LS capable of blocking the light.

A second active buffer layer ABUF2 may be disposed on the first metal layer ML1 and the second metal layer ML2. An active layer ACT of a driving transistor DRT may be disposed on the second active buffer layer ABUF2.

A gate insulating film GI may be disposed while covering the active layer ACT.

A first gate electrode GATE1 of a driving transistor DRT may be disposed on the gate insulating film GI. In this case, a gate material layer GM may be disposed on the gate insulating film GI together with the first gate electrode GATE1 of the driving transistor DRT at a position different from the formation position of the driving transistor DRT.

A first interlayer insulating film ILD1 may be disposed while covering the first gate electrode GATE1 and the gate material layer GM. A metal pattern TM may be disposed on the first interlayer insulating film ILD1. The metal pattern TM may be located at a different location from the formation location of the driving transistor DRT. A second interlayer insulating film ILD2 may be disposed while covering the metal pattern TM on the first interlayer insulating film II,D1.

Two first source-drain electrode patterns SD1 may be disposed on the second interlayer insulating film ILD2. One of the two first source-drain electrode patterns SD1 may be a source node of the driving transistor DRT, and the other may be a drain node of the driving transistor DRT. The two first source-drain electrode patterns SD1 may be electrically connected to one side and the other side of the active layer ACT through the contact holes of the second interlayer insulating film ILD2, the first interlayer insulating film ILD1 and the gate insulating film GI.

A portion of the active layer ACT overlapping with the first gate electrode GATE1 may be a channel region. One of the two first source-drain electrode patterns SD1 may be connected to one side of the channel region in the active layer ACT, and the other of the two first source-drain electrode patterns SD1 may be connected to the other side of the channel region in the active layer ACT.

A passivation layer PAS0 may be disposed to cover the two first source-drain electrode patterns SD1. A planarization layer PLN may be disposed on the passivation layer PAS0. The planarization layer PLN may include a first planarization layer PLN1 and a second planarization layer PLN2.

The first planarization layer PLN1 may be disposed on the passivation layer PAS0.

A second source-drain electrode pattern SD2 may be disposed on the first planarization layer PLN1. The second source-drain electrode pattern SD2 may be connected to one of the two first source-drain electrode patterns SD1 (corresponding to the second node N2 of the driving transistor DRT in the subpixel SP of FIG. 3) through the contact hole of the first planarization layer PLN1.

A second planarization layer PLN2 may be disposed while covering the second source-drain electrode pattern SD2. A light emitting device ED may be disposed on the second planarization layer PLN2.

In a stacked structure of the light emitting device ED, an anode electrode AE may be disposed on the second planarization layer PLN2. The anode electrode AE may be electrically connected to the second source-drain electrode pattern SD2 through a contact hole of the second planarization layer PLN2.

A bank BANK may be disposed to cover a part of the anode electrode AE. A part of the bank BANK corresponding to a light emission area EA of the subpixel SP may be opened.

A part of the anode electrode AE may be exposed to an opening (e.g., open portion) of the bank BANK. An emission layer EL may be located on a side of the bank BANK and in the opening (e.g., open portion) of the bank BANK. All or a part of the emission layer EL may be located between adjacent banks BANK.

In the opening of the bank BANK, the emission layer EL may be in contact with the anode electrode AE. A cathode electrode CE may be disposed on the emission layer EL.

A light emitting device ED may be formed by the anode electrode AE, the emission layer EL and the cathode electrode CE. The emission layer EL may include an organic film.

An encapsulation layer ENCAP may be disposed on the light emitting device ED.

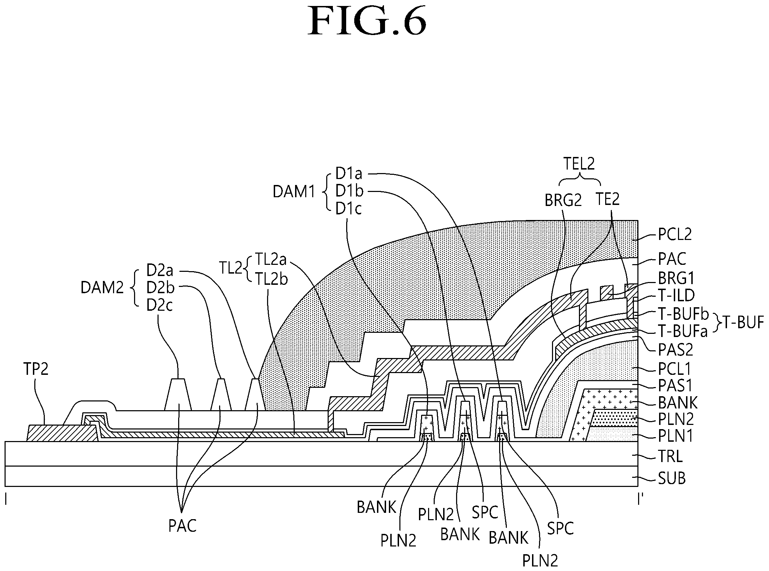

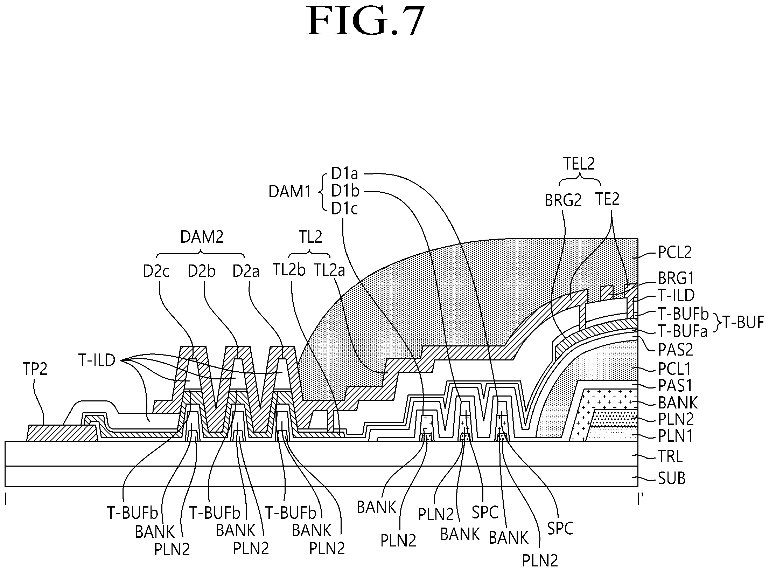

The encapsulation layer ENCAP may have a single-layer structure or a multi-layer structure. For example, as illustrated in FIGS. 6 and 7, the encapsulation layer ENCAP may include a first inorganic encapsulation layer PAS 1, an organic encapsulation layer PCL and a second inorganic encapsulation layer PAS2.

For example, the first inorganic encapsulation layer PAS 1 and the second inorganic encapsulation layer PAS2 may be inorganic films, and the organic encapsulation layer PCL may be an organic film. Among the first inorganic encapsulation layer PAS 1, the organic encapsulation layer PCL, and the second inorganic encapsulation layer PAS2, the organic encapsulation layer PCL may be the thickest, and may act as a planarizing layer.

The first inorganic encapsulation layer PAS 1 may be disposed on the cathode electrode CE, and may be disposed closest to the light emitting device ED. The first inorganic encapsulation layer PAS 1 may be formed of an inorganic insulating material capable of low-temperature deposition. For example, the first inorganic encapsulation layer PAS1 may include silicon nitride (SiNx), silicon oxide (SiOx), silicon oxynitride (SiON), aluminum oxide (Al12O3), and the like. Since the first inorganic encapsulation layer PAS 1 is deposited in a low-temperature atmosphere, the first inorganic encapsulation layer PAS 1 may prevent the emission layer EL including an organic material vulnerable to a high-temperature atmosphere from being damaged during the deposition process.

The organic encapsulation layer PCL may be formed with a smaller area than the first inorganic encapsulation layer PAS1. In this case, the organic encapsulation layer PCL may be formed to expose both ends of the first inorganic encapsulation layer PAS1. The organic encapsulation layer PCL may act as a buffer to relieve stress between each layer due to the bending of the display device 100, and may also act to enhance the flattening performance. For example, the organic encapsulation layer PCL may be made of an acrylic resin, an epoxy resin, a polyimide, polyethylene, or a silicon oxycarbon SiOC, and may be formed of an organic insulating material. For example, the organic encapsulation layer PCL may be formed through an inkjet process.

The second inorganic encapsulation layer PAS2 may be formed on the substrate SUB on which the organic encapsulation layer PCL is formed, so as to cover the upper surface and side surface of each of the organic encapsulation layer PCL and the first inorganic encapsulation layer PAS1. The second inorganic encapsulation layer PAS2 may minimize or block external moisture or oxygen from penetrating into the first inorganic encapsulation layer PAS1 and the organic encapsulation layer PCL. For example, the second inorganic encapsulation layer PAS2 may be formed of an inorganic insulating material such as silicon nitride (SiNx), silicon oxide (SiOx), silicon oxynitride (SiON), or aluminum oxide (Al2O3).

Referring to FIG. 4, if the touch sensor TS is of a type built into the display panel 110, the touch sensor TS may be disposed on the encapsulation layer ENCAP. The touch sensor structure will be described in detail as follows.

A touch buffer film T-BUF may be disposed on the encapsulation layer ENCAP. The touch sensor TS may be disposed on the touch buffer film T-BUF.

The touch sensor TS may include a touch sensor metal TSM and a bridge metal BRG located in different layers.

A touch interlayer insulating film T-ILD may be disposed between the touch sensor metal TSM and the bridge metal BRG.

For example, the touch sensor metal TSM may include a first touch sensor metal TSM, a second touch sensor metal TSM, and a third touch sensor metal TSM disposed adjacent to each other. If the third touch sensor metal TSM is located between the first touch sensor metal TSM and the second touch sensor metal TSM, and the first touch sensor metal TSM and the second touch sensor metal TSM are required to be electrically connected to each other, the first touch sensor metal TSM and the second touch sensor metal TSM may be electrically connected to each other through the bridge metal BRG located in a different layer. The bridge metal BRG may be insulated from the third touch sensor metal TSM by the touch interlayer insulating film T-ILD.

When the touch sensor TS is formed on the display panel 110, there may be generated a chemical solution (e.g., developer solution or etchant, etc.) used in the process or moisture from the outside. Since the touch sensor TS is disposed on the touch buffer film T-BUF, there may prevent the chemical solution or moisture from penetrating into the emission layer EL containing an organic material during the manufacturing process of the touch sensor TS. Accordingly, the touch buffer film T-BUF may prevent damage to the emission layer EL vulnerable to the chemical solution or moisture.

The touch buffer film T-BUF may be formed at a low temperature condition below a specific temperature (e.g., 100 degrees (°C)), and may be formed of an organic insulating material having a low permittivity of 1 to 3 in order to prevent damage to the emission layer EL containing an organic material which is vulnerable to high temperatures. For example, the touch buffer film T-BUF may be formed of an acrylic series, an epoxy series, or a siloxane series material. As the display device 100 bends, the encapsulation layer ENCAP may be damaged and the touch sensor metal positioned on the touch buffer film T-BUF may be broken or disconnected. Even if the display device 100 bends, the touch buffer film T-BUF having flattening performance made of an organic insulating material may prevent damage to the encapsulation layer ENCAP and/or breakage of the metal TSM or BRG forming the touch sensor TS.

A protective layer PAC may be disposed while covering the touch sensor TS. The protective layer PAC may be an organic insulating film.

The display device according to embodiments of the present disclosure may sense a touch using a mutual-capacitance-based touch sensing method, or may sense a touch using a self-capacitance-based touch sensing method. However, hereinafter, for convenience of explanation, it will be described as an example that the display device performs mutual-capacitance-based touch sensing and has a touch sensor structure therefor.

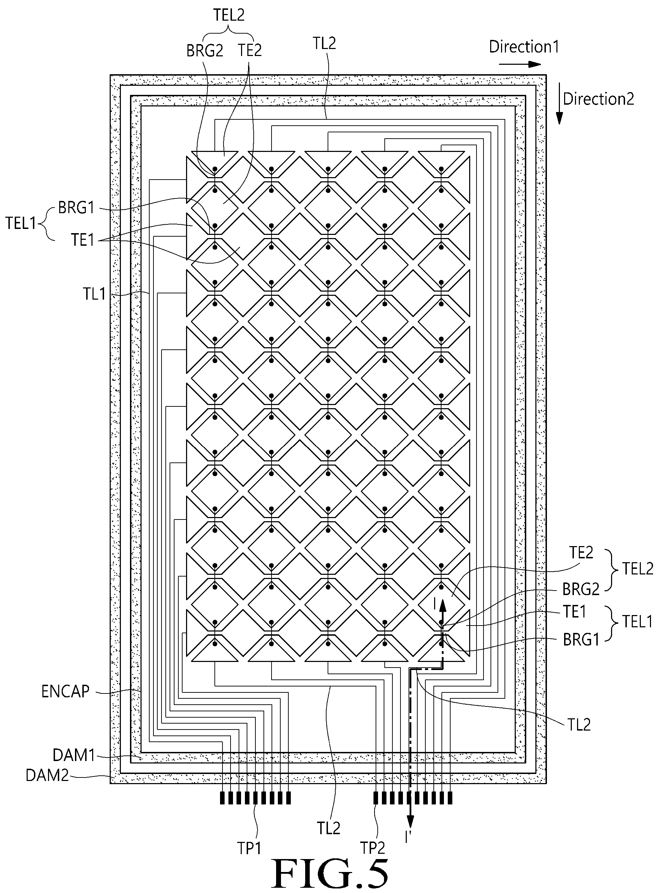

FIG. 5 is a diagram related to configurations for touch sensing according to embodiments of the present disclosure.

Referring to FIG. 5, a touch sensor structure for mutual-capacitance-based touch sensing may include a plurality of first touch electrode lines TEL1 and a plurality of second touch electrode lines TEL2. Here, the plurality of first touch electrode lines TEL1 and the plurality of second touch electrode lines TEL2 may be located on an encapsulation layer ENCAP.

Each of the plurality of first touch electrode lines TEL1 may be disposed in a first direction (e.g., direction1), and each of the plurality of second touch electrode lines TEL2 may be disposed in a second direction (e.g., direction2). The first direction and the second direction may intersect each other.

Referring to FIG. 5, each of the plurality of first touch electrode lines TEL1 may include a plurality of first touch electrodes TE1 electrically connected to each other. Each of the plurality of second touch electrode lines TEL2 include a plurality of second touch electrodes TE2 which are electrically connected to each other. The plurality of first touch electrodes TE1 and the plurality of second touch electrodes TE2 may be included in the plurality of touch electrodes (TE). The plurality of first touch electrodes TE1 constituting each of the plurality of first touch electrode lines TEL1 may be driving touch electrodes, and the plurality of second touch electrodes TE2 constituting each of the plurality of second touch electrode lines TEL2 may be sensing touch electrodes. In this case, each of the plurality of first touch electrode lines TEL1 may correspond to a driving touch electrode line, and each of the plurality of second touch electrode lines TEL2 may correspond to a sensing touch electrode line.

Referring to FIG. 5, the touch sensor metal for touch sensing may include a plurality of touch routing lines TL in addition to the plurality of first touch electrode lines TEL1 and the plurality of second touch electrode lines TEL2. The plurality of touch routing lines TL may include one or more first touch routing lines TL1 connected to each of the plurality of first touch electrode lines TEL1, and one or more second touch routing lines TL2 connected to each of the plurality of second touch electrode lines TEL2.

Referring to FIG. 5, each of the plurality of first touch electrode lines TEL1 may include a plurality of first touch electrodes TE1 arranged in the same row (or column) and one or more first bridge metals BRG1 electrically connecting the plurality of first touch electrodes TE1. Here, the first bridge metal BRG1 connecting two adjacent first touch electrodes TE1 may be a metal integrated with the two adjacent first touch electrodes TE1, or may be a metal connected to the two adjacent first touch electrodes TE1 through a contact hole.

Each of the plurality of second touch electrode lines TEL2 may include a plurality of second touch electrodes TE2 arranged in the same column (or row) and one or more second bridge metals BRG2 electrically connecting the plurality of second touch electrodes TE2. Here, the second bridge metal BRG2 connecting two adjacent second touch electrodes TE2 may be a metal integrated with the two adjacent second touch electrodes TE2, or may be a metal connected to two adjacent second touch electrodes TE2 through a contact hole.

Here, the first bridge metal BRG1 or the second bridge metal BRG2 connected to the first touch electrode TE1 or the second touch electrode TE2 through the contact hole may be referred to as a "connection pattern."

In the area where the first touch electrode line TEL1 and the second touch electrode line TEL2 intersect (*i.e.,* touch electrode line intersection area), the first bridge metal BRG1 and the second bridge metal BRG2 may intersect.

In this way, in the touch electrode line intersection area, since the first bridge metal BRG1 and the second bridge metal BRG2 intersect, the first bridge metal BRG1 and the second bridge metal BRG2 may be disposed in different layers.

Therefore, in order for the plurality of first touch electrode lines TEL1 and the plurality of second touch electrode lines TEL2 to be arranged to intersect, the plurality of first touch electrodes TE1, the plurality of first bridge metals BRG1, the plurality of second touch electrodes TE2, the plurality of second touch electrode lines TEL2, and the plurality of second bridge metals BRG2 may be disposed in two or more layers.

Referring to FIG. 5, each of the plurality of first touch electrode lines TEL1 may be electrically connected to the corresponding first touch pad TP1 through one or more first touch routing lines TL1. That is, the first touch electrode TE1 disposed at the outermost end among the plurality of first touch electrodes TE1 included in one first touch electrode line TEL1 may be electrically connected to the corresponding first touch pad TP1 through the first touch routing line TL1.

Each of the plurality of second touch electrode lines TEL2 may be electrically connected to the corresponding second touch pad TP2 through one or more second touch routing lines TL2. That is, the second touch electrode TE2 disposed at the outermost end among the plurality of second touch electrodes TE2 included in one second touch electrode line TEL2 may be electrically connected to the corresponding second touch pad TP2 through the second touch routing line TL2.

Referring to FIG. 5, a dam DAM may be disposed on the outside of the encapsulation layer ENCAP. The touch routing lines TL1 and TL2 may be electrically connected to touch pads TP1 and TP2 passing through an area where the dam DAM is disposed. Referring to FIG. 5, there may be defined an I-I' area. Hereinafter, a cross-sectional view of the I-I' area will be described with reference to FIGS. 6, 7, and 8.

FIG. 6 is a cross-sectional view of an outer dam DAM2 as a protective layer PAC according to embodiments of the present disclosure.

Referring to FIG. 6, the substrate SUB may be disposed at the bottom or the lowest position of the display panel 110.

Referring to FIG. 6, a transistor layer TRL may be disposed on the substrate SUB. The transistor layer TRL may include various patterns (e.g., ACT, SD1, GATE1), various insulating films or insulating layers (e.g., MBUF, ABUF1, ABUF2, GI, ILD1, ILD2, PAS0) and various metal patterns (e.g., TM, GM, MI,1, ML2) for forming the transistor illustrated in FIG. 4. In addition, the transistor layer TRL is simply illustrated for convenience of explanation.

Referring to FIG. 6, a first planarization layer PLN1 may be disposed on the transistor layer TRL.

Referring to FIG. 6, a second planarization layer PLN2 may be disposed on an upper portion of the first planarization layer PLN1. After the second planarization layer PLN2 is entirely deposited on the first planarization layer PLN1, a portion of the second planarization layer PLN2 may be removed through an etching process. A portion of the etched second planarization layer PLN2 may be included in each of a first inner dam D1a, a second inner dam D1b, and a third inner dam D1c.

Referring to FIG. 6, the bank BANK may be disposed on an upper portion of the second planarization layer PLN2. After the bank BANK is entirely deposited on the second planarization layer PLN2, a portion of the bank BANK may be removed through an etching process.

A portion of the etched bank BANK may be included in each of the first inner dam D1a, the second inner dam D1b, and the third inner dam D1c. The bank BANK of the first inner dam D1a may be disposed to cover the second planarization layer PLN2 of the first inner dam D1a. The bank BANK of the second inner dam D1b may be disposed to cover the second planarization layer PLN2 of the second inner dam D1b. The bank BANK of the third inner dam D1c may be disposed to cover the second planarization layer PLN2 of the third inner dam D1c.

Referring to FIG. 6, the first inner dam D1a may further include a spacer SPC. The spacer SPC of the first inner dam D1a may be disposed on the bank BANK of the first inner dam D1a.

Referring to FIG. 6, the second inner dam D1b may further include a spacer SPC. The spacer SPC of the second inner dam D1b may be disposed on the bank BANK of the second inner dam D1b.

Referring to FIG. 6, a first inorganic encapsulation layer PAS1 may be disposed to cover the bank BANK, the first inner dam D1a, the second inner dam D1b and the third inner dam D1c. The first inorganic encapsulation layer PAS1 may be disposed to contact the transistor layer TRL exposed by the etched bank BANK layer.

Referring to FIG. 6, a first organic encapsulation layer PCL1 may be disposed on the first inorganic encapsulation layer PAS1. The first organic encapsulation layer PCL1 may be formed using an inkjet method. In this case, the first organic encapsulation layer PCL1 may overflow out of the display panel 110. Referring to FIG. 6, since the inner dams DAM1 are formed before disposing the first organic encapsulation layer PCL1, the first organic encapsulation layer PCL1 may not overflow into the non-display area.

Referring to FIG. 6, the first inner dam D1a may be disposed on the outer side of the first organic encapsulation layer PCL1. The second inner dam D1b may be disposed on the outer side of the first inner dam D1a. The third inner dam D1c may be disposed on the outer side of the second inner dam D1b. In some embodiments, the height of the first inner dam D1a or the second inner dam D1b is greater than the height of the third inner dam D1c.

Referring to FIG. 6, the first organic encapsulation layer PCL1 may be disposed in contact with the first inorganic encapsulation layer PAS1. A thickness of the first organic encapsulation layer PCL1 may be greater than a thickness of the first inorganic encapsulation layer PAS1 and a thickness of a second inorganic encapsulation layer PAS2.

Referring to FIG. 6, the second inorganic encapsulation layer PAS2 may be disposed to cover the first organic encapsulation layer PCL1 and the first inorganic encapsulation layer PAS1. The second inorganic encapsulation layer PAS2 may be disposed in contact with the first inorganic encapsulation layer PAS1 overlapping with the first inner dam D1a. The second inorganic encapsulation layer PAS2 may be disposed in contact with the first inorganic encapsulation layer PAS1 overlapping with the second inner dam D1b. The second inorganic encapsulation layer PAS2 may be disposed in contact with the first inorganic encapsulation layer PAS1 overlapping with the third inner dam D1c. The second inorganic encapsulation layer PAS2 may be disposed in contact with the transistor layer TRL beyond the first inorganic encapsulation layer PAS1 overlapping with the third inner dam D1c.

Referring to FIG. 6, the touch buffer film T-BUF may include a first touch buffer film T-BUFa and a second touch buffer film T-BUFb.

Referring to FIG. 6, the first touch buffer film T-BUFa may be disposed to cover the second inorganic encapsulation layer PAS2. The first touch buffer film T-BUFa may be an inorganic film. The first touch buffer film T-BUFa may be disposed beyond an area where the inner dam DAM1 is disposed.

Referring to FIG. 6, a second bridge metal BRG2 may be disposed on the first touch buffer film T-BUFa. Referring to FIG. 6, a portion of the second bridge metal BRG2 may be disposed on the first organic encapsulation layer PCL1.

Referring to FIG. 6, a second touch routing line TL2 may include an upper touch routing line TL2a and a lower touch routing line TL2b.

The lower touch routing line TL2b may be disposed at a lower portion of the outer dam DAM2, and the lower touch routing line TL2b may be electrically connected to a second touch pad TP2. Referring to FIG. 6, the lower touch routing line TL2b electrically connected to the second touch pad TP2 may be disposed at the outer side of the inner dams DAM1.

Referring to FIG. 6, the second touch buffer film T-BUFb may be disposed to cover the lower touch routing line TL2b, the second bridge metal BRG2 and the first touch buffer film T-BUFb. The second touch buffer film T-BUFa may be an inorganic film. A portion of the second touch buffer film T-BUFb may be disposed to be in contact with the second touch pad TP2.

Referring to FIG. 6, a touch interlayer insulating film T-ILD may be disposed on the second touch buffer film T-BUFb. The touch interlayer insulating film T-ILD may be an inorganic film or an organic film. In the case that the touch interlayer insulating film T-ILD is an organic film, a thickness of the touch interlayer insulating film T-ILD made of an organic film may be greater than a thickness of the touch interlayer insulating film T-ILD made of an inorganic film.

Referring to FIG. 6, a second touch electrode TE2 may be disposed on the touch interlayer insulating film T-ILD. A portion of the second touch electrode TE2 may be disposed to overlap with the second bridge metal BRG2. The second touch electrode TE2 may be electrically connected to the second bridge metal BRG2 through a contact hole formed in the touch interlayer insulating film T-ILD. Referring to FIG. 6, a portion of the second touch electrode TE2 may be disposed to contact the second bridge metal BRG2 on the first organic encapsulation layer PCL1.

Referring to FIG. 6, the upper touch routing line TL2a may be disposed to contact the lower touch routing line TL2b electrically connected to the second touch pad TP2.

Referring to FIG. 6, a first bridge metal BRG1 may be disposed on the touch interlayer insulating film T-ILD. The first bridge metal BRG1 may be disposed to overlap with the second bridge metal BRG2.

Referring to FIG. 6, a protective layer PAC may be disposed to cover the second touch electrode TE2, the upper touch routing line TL2a and the touch interlayer insulating film T-ILD. After entirely depositing the protective layer PAC on the touch interlayer insulating film T-ILD, a portion of the protective layer PAC may be removed through an etching process.

Referring to FIG. 6, the protective layer PAC may be disposed to expose a portion of the touch interlayer insulating film T-ILD. A portion of the etched protective layer PAC may be disposed around an area where a portion of the touch interlayer insulating film T-ILD is exposed. A portion of the etched protective layer PAC may be referred to as an outer dam D2a, D2b and D2c. The outer dams D2a, D2b and D2c may include a first outer dam D2a, a second outer dam D2b, and a third outer dam D2c. The second outer dam D2b may be disposed on the outer side of the first outer dam D2a. The third outer dam D2c may be disposed on the outer side of the second outer dam D2b.

Referring to FIG. 6, the second organic encapsulation layer PCL2 may be disposed on the protective layer PAC. The second organic encapsulation layer PCL2 may be formed using an inkjet method. In this case, the second organic encapsulation layer PCL2 may overflow out of the display panel 110. Referring to FIG. 5, since the outer dams DAM2 are formed before disposing the second organic encapsulation layer PCL2, the second organic encapsulation layer PCL2 may not overflow out of the display panel 110.

Referring to FIG. 6, the lower touch routing line TL2b may be disposed under the outer dams D2a, D2b and D2c. The lower touch routing line TL2b may be covered with a second touch buffer film T-BUFb, the touch interlayer insulating film T-ILD, and the outer dams D2a, D2b and D2c. That is, the lower touch routing line TL2b may be disposed so as not to be exposed to the outside. Accordingly, the lower touch routing line TL2b may be protected without being corroded.

Meanwhile, referring to FIG. 6, the protective layer PAC may be disposed under the second organic encapsulation layer PCL2. In order to increase process efficiency, there may be omitted a mask process for forming the protective layer PAC. Accordingly, the display panel 110 may not include a protective layer PAC. Hereinafter, it will be described a display panel 110 which does not include a protective layer PAC with reference to FIG. 7. It will may be omitted a description of a configuration which is the same as a configuration of the display panel 110 illustrated in FIG. 6 among the configurations of the display panel 110 illustrated in FIG. 7.

FIG. 7 is a cross-sectional view of an outer dam DAM2 including an upper touch routing line TL2a according to embodiments of the present disclosure.

Referring to FIG. 7, there is illustrated that the protective layer PAC of FIG. 6 is not disposed under a second organic encapsulation layer PCL2 in FIG. 7. Therefore, the second organic encapsulation layer PCL2 may be disposed to cover a second touch electrode TE2, a first bridge metal BRG1, and an upper touch routing line TL2a.

Referring to FIG. 7, an outer dam DAM2 illustrated in FIG. 7 may have a different configuration from the outer dam DAM2 illustrated in FIG. 6.

Referring to FIG. 7, the outer dam DAM2 may include a portion of a second planarization layer PLN2, a portion of a bank BANK, a portion of a first touch buffer film T-BUFa, a lower touch routing line TL2b, a portion of a second touch buffer film T-BUFb, a portion of a touch interlayer insulating film T-ILD, and an upper touch routing line TL2a.

The second planarization layer PLN2 of a first outer dam D2a may be disposed on a transistor layer TRL.

The bank BANK of the first outer dam D2a may be disposed to cover the second planarization layer PLN2 of the first outer dam (D2a).

The first touch buffer film T-BUFa of the first outer dam D2a may be disposed to cover the bank BANK of the first outer dam D2a.

The lower touch routing line TL2b of the first outer dam D2a may be disposed on the first touch buffer film T-BUFa of the first outer dam D2a.

The second touch buffer film T-BUFb of the first outer dam D2a may be disposed on the lower touch routing line TL2b of the first outer dam D2a.

The touch interlayer insulating film T-ILD of the first outer dam D2a may be disposed to cover the second touch buffer film T-BUFb of the first outer dam D2a.

The upper touch routing line TL2a of the first outer dam D2a may be disposed on the touch interlayer insulating film T-ILD of the first outer dam D2a.

A second outer dam D2b may be disposed on the outer side of the first outer dam D2a. The configuration of the second outer dam D2b may be the same as the configuration of the first outer dam D2a.

A third outer dam D2c may be disposed on the outer side of the second outer dam D2b. The configuration of the third outer dam D2c may be the same as the configuration of the second outer dam D2b.

Each of the portions of the etched second planarization layer PLN2 may be included in the first outer dam D2a, the second outer dam D2b, and the third outer dam D2c.

Each of the portions of the etched bank BANK may be included in the first outer dam D2a, the second outer dam D2b, and the third outer dam D2c.

The first touch buffer film T-BUFa may be included in the first outer dam D2a, the second outer dam D2b and the third outer dam D2c in a form of covering portions of the etched bank BANK.

The lower touch routing line TL2b may be disposed in contact with the first touch buffer film T-BUFa, but may be disposed in a form that passes over the first touch buffer film T-BUFa. That is, the lower touch routing line TL2b may be included in the first outer dam D2a, the second outer dam D2b and the third outer dam D2c in an unbroken form.

Each of the portions of the etched second touch buffer film T-BUFb may be included in the first outer dam D2a, the second outer dam D2b, and the third outer dam D2c.

Each of the portions of the etched touch interlayer insulating film T-ILD may be included in the first outer dam D2a, the second outer dam D2b, and the third outer dam D2c.

The upper touch routing line TL2a may be disposed in contact with the touch interlayer insulating film T-ILD, but may be disposed in a form that passes over the touch interlayer insulating film T-ILD. That is, the upper touch routing line TL2a may be included in the first outer dam D2a, the second outer dam D2b and the third outer dam D2c in an unbroken form.

In this case, the upper touch routing line TL2a may be disposed in contact with the lower touch routing line TL2b. In an area where the outer dam DAM2 is disposed, the upper touch routing line TL2a may be disposed in contact with the lower touch routing line TL2b. That is, the upper touch routing line TL2a may be disposed in contact with the lower touch routing line TL2b even in an area other than a contact hole of the touch interlayer insulating film T-ILD formed on the outer side of an inner dam DAM1.

Since the upper touch routing line TL2a is in contact with the lower touch routing line TL2b at two or more points, even if a part of the second touch routing line TL2 is damaged, a signal can be transmitted through the second touch routing line TL2.

Meanwhile, since the upper touch routing line TL2a is disposed to cover the lower touch routing line TL2b, the upper touch routing line TL2a may prevent corrosion of the lower touch routing line TL2b due to external exposure. However, since the upper touch routing line TL2a may also be exposed to the outside, in this case, there may be required to dispose an additional insulating layer.

Hereinafter, it will be described a structure of the display panel 110 capable of preventing corrosion of the lower touch routing line TL2b by using a touch interlayer insulating film T-ILD.

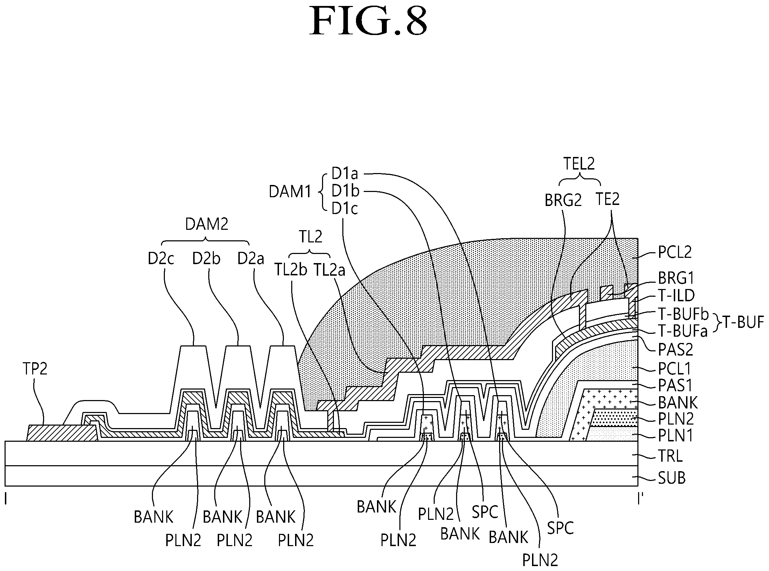

FIG. 8 is a cross-sectional view of an outer dam DAM2 including a touch interlayer insulating film T-ILD according to embodiments of the present disclosure.

Referring to FIG. 8, there is illustrated a case in which a protective layer PAC illustrated in FIG. 6 is not disposed under a second organic encapsulation layer PCL2 in FIG. 8. Therefore, the second organic encapsulation layer PCL2 may be disposed to cover a second touch electrode TE2, a first bridge metal BRG1, and an upper touch routing line TL2a.

Referring to FIG. 8, an outer dam DAM2 may include a portion of a second planarization layer PLN2, a portion of a bank BANK, a portion of a first touch buffer film T-BUFa, a portion of a lower touch routing line TL2b, a portion of a second touch buffer film T-BUFb, and a portion of the touch interlayer insulating film T-ILD.

The second planarization layer PLN2 of a first outer dam D2a may be disposed on a transistor layer TRL.

The bank BANK of the first outer dam D2a may be disposed to cover the second planarization layer PLN2 of the first outer dam D2a.

The first touch buffer film T-BUFa of the first outer dam D2a may be disposed to cover the bank BANK of the first outer dam D2a.

The lower touch routing line TL2b of the first outer dam D2a may be disposed on the first touch buffer film T-BUFa of the first outer dam D2a.

The second touch buffer film T-BUFb of the first outer dam D2a may be disposed to cover the lower touch routing line TL2b of the first outer dam D2a.

The touch interlayer insulating film T-ILD of the first outer dam D2a may be disposed to cover the second touch buffer film T-BUFb of the first outer dam D2a.

A second outer dam D2b may be disposed on the outer side of the first outer dam D2a. The configuration of the second outer dam D2b may be the same as the configuration of the first outer dam D2a.

A third outer dam D2c may be disposed on the outer side of the second outer dam D2b. The configuration of the third outer dam D2c may be the same as the configuration of the second outer dam D2b.

Each of the portions of the etched second planarization layer PLN2 may be included in the first outer dam D2a, the second outer dam D2b, and the third outer dam D2c.

Each of the portions of the etched bank BANK may be included in the first outer dam D2a, the second outer dam D2b, and the third outer dam D2c.

The first touch buffer film T-BUFa may be included in the first outer dam D2a, the second outer dam D2b and the third outer dam D2c in a form that covers portions of the etched bank BANK.

The lower touch routing line TL2b may be disposed in contact with the first touch buffer film T-BUFa, but may be arranged in a form that passes over the first touch buffer film T-BUFa. That is, the lower touch routing line TL2b may be included in the first outer dam D2a, the second outer dam D2b and the third outer dam D2c in an unbroken form.

The second touch buffer film T-BUFb may be included in the first outer dam D2a, the second outer dam D2b, and the third outer dam D2c in a form that covers the lower touch routing line TL2b.

The touch interlayer insulating film T-ILD may be included in the first outer dam D2a, the second outer dam D2b, and the third outer dam D2c in a form that covers the second touch buffer film T-BUFb.

Since the touch interlayer insulating film T-ILD is arranged to cover the lower touch routing line TL2b, the touch interlayer insulating film T-ILD can prevent corrosion of the lower touch routing line TL2b due to external exposure.

There may be performed a halftone process when forming the touch interlayer insulating film T-ILD. Therefore, a thickness of an upper surface of the touch interlayer insulating film T-ILD may be greater than a thickness of the side surface of the touch interlayer insulating film T-ILD. The side of the touch interlayer insulating film T-ILD may be formed relatively thin so that a V-shaped bend may be formed deeper between the outer dams DAM2. In addition, the upper surface of the touch interlayer insulating film T-ILD may be formed relatively thick so as for the height of the outer dam DAM2 to be increased.

Referring to FIG. 8, the touch interlayer insulating film T-ILD may be disposed in contact with the second organic encapsulation layer PCL2. The side of the touch interlayer insulating film T-ILD may be disposed in contact with the second organic encapsulation layer PCL2, and in some cases, the second organic encapsulation layer PCL2 may be disposed in contact with the upper surface of the touch interlayer insulating film T-ILD.

Referring to FIG. 8, the second organic encapsulation layer PCL2 may be formed by an inkjet method. In this case, the second organic encapsulation layer PCL2 may overflow out of the display panel 110. Referring to FIG. 5, since the outer dams DAM2 are formed before forming the second organic encapsulation layer PCL2, the second organic encapsulation layer PCL2 may not overflow out of the display panel 110.

Referring to FIG. 8, a second touch electrode TE2 may be disposed on the touch interlayer insulating film T-ILD. A portion of the second touch electrode TE2 may be disposed to overlap with a second bridge metal BRG2. The second touch electrode TE2 may be electrically connected to the second bridge metal BRG2 through a contact hole formed in the touch interlayer insulating film T-ILD. Referring to FIG. 8, a portion of the second touch electrode TE2 may be disposed to contact the second bridge metal BRG2 on a first organic encapsulation layer PCL1.

Referring to FIG. 8, an upper touch routing line TL2a may be disposed to contact a lower touch routing line TL2b electrically connected to a second touch pad TP2.

Referring to FIG. 8, a first bridge metal BRG1 may be disposed on the touch interlayer insulating film T-ILD. The first bridge metal BRG1 may be disposed to overlap with the second bridge metal BRG2.

Referring to FIG. 8, a first inner dam D1a may further include a spacer SPC. The spacer SPC of the first inner dam D1a may be disposed on the bank BANK of the first inner dam D1a.

Referring to FIG. 8, a second inner dam D1b may further include a spacer SPC. The spacer SPC of the second inner dam D1b may be disposed on the bank BANK of the second inner dam D1b.

Referring to FIG. 8, a first inorganic encapsulation layer PAS 1 may be disposed to cover the bank BANK, the first inner dam D1a, the second inner dam D1b and a third inner dam D1c. The first inorganic encapsulation layer PAS1 may be disposed to contact s transistor layer TRL exposed by an etched bank BANK layer.

Referring to FIG. 8, an inner dam DAM1 may be disposed to overlap with a second organic encapsulation layer PCL2. The second organic encapsulation layer PCL2 may be disposed to be spaced apart from the inner dam DAM1, but may be disposed to pass over the inner dam DAM1 and contact the side surface SS of the outer dam DAM2. Referring to FIG. 8, the second organic encapsulation layer PCL2 may be disposed in contact with the side surface SS of the first outer dam D2a.

Referring to FIG. 8, a first organic encapsulation layer PCL1 may be disposed on the first inorganic encapsulation layer PAS1. The first organic encapsulation layer PCL1 may be formed using an inkjet method. In this case, the first organic encapsulation layer PCL1 may overflow out of the display panel 110. Referring to FIG. 8, since the inner dams DAM1 are formed before the first organic encapsulation layer PCL1 is disposed, the first organic encapsulation layer PCL1 may not overflow into the non-display area.

According to embodiments of the present disclosure, it is possible to provide a display device including an outer dam capable of preventing an organic film from overflowing.

According to embodiments of the present disclosure, it is possible to provide a display device including an outer dam capable of protecting touch routing line.

According to embodiments of the present disclosure, it is possible to provide a display device with increased process efficiency by the outer dam capable of protecting the touch routing line.

Embodiments of the present disclosure described above are briefly described as follows.

A display device according to embodiments of the present disclosure may include a substrate including a display area, a dam area, and a pad area, a planarization layer disposed on the substrate, a bank disposed on the planarization layer, a first encapsulation layer disposed on the bank, a first bridge metal disposed on the first encapsulation layer, a lower touch routing line disposed on the first encapsulation layer and extending to the dam area, a touch interlayer insulating film disposed on the first bridge metal and the lower touch routing line, a touch sensor metal electrically connected to the first bridge metal and disposed on the touch interlayer insulating film, and a second encapsulation layer disposed on the touch sensor metal and disposed on the inner side of the touch interlayer insulating film disposed in the dam area.

The display device according to embodiments of the present disclosure may further include an outer dam disposed in the dam area. The outer dam may include the lower touch routing line, a touch buffer film covering the lower touch routing line in the dam area, and the touch interlayer insulating film covering the touch buffer film in the dam area.

The touch interlayer insulating film included in the outer dam may have a thickness on an upper surface greater than a thickness on a side surface.

The outer dam may include a first outer dam disposed on an outer side of the second encapsulation layer, and a second outer dam disposed on an outer side of the first outer dam.

A side surface of the outer dam may be disposed in contact with the second encapsulation layer.

The display device according to embodiments of the present disclosure may further include an upper touch routing line electrically connected to the touch sensor metal and the lower touch routing line, and a touch pad electrically connected to the lower touch routing line and disposed in the pad area.

The upper touch routing line may be disposed on the touch interlayer insulating film, and may be electrically connected to the lower touch routing line through a contact hole of the touch interlayer insulating film.

The display device according to embodiments of the present disclosure may further include a second bridge metal disposed on the touch interlayer insulating film, and at least partially overlapping with the first bridge metal.

The display device according to embodiments of the present disclosure may further include a first inner dam disposed on the outer side of the first encapsulation layer, and a second inner dam disposed between the first inner dam and the outer dam. The first inner dam and the second inner dam may overlap with the second encapsulation layer.

A height of the first inner dam may be greater than a height of the second inner dam.

The second encapsulation layer may be an organic insulating film.

The second encapsulation layer may include one of acrylic resin, epoxy resin, polyimide, polyethylene, or siliconoxycarbon.

The second encapsulation layer may be formed through an inkjet process.

The display device according to embodiments of the present disclosure may further include an emission layer disposed below the first encapsulation layer.

The above description and the accompanying drawings provide an example of the technical idea of the present disclosure for illustrative purposes only. Various modifications, additions and substitutions to the described embodiments will be readily apparent to those skilled in the art without departing from the scope of the present disclosure. In addition, the disclosed embodiments are intended to illustrate the scope of the technical idea of the present disclosure. Thus, the scope of the present disclosure is not limited to the embodiments shown.

The various embodiments described above can be combined to provide further embodiments. Aspects of the embodiments can be modified, if necessary to employ concepts of the various patents, applications and publications referred to in this specification to provide yet further embodiments.

These and other changes can be made to the embodiments in light of the abovedetailed description. In general, in the following claims, the terms used should not be construed to limit the claims to the specific embodiments disclosed in the specification and the claims, but should be construed to include all possible embodiments along with the full scope of equivalents to which such claims are entitled. Accordingly, the claims are not limited by the disclosure.

## Claims

1. A display device comprising:
a substrate including a display area, a dam area, and a pad area;
a planarization layer on the substrate;
a bank on the planarization layer;
a first encapsulation layer on the bank;
a first bridge metal on the first encapsulation layer;
a lower touch routing line on the first encapsulation layer and extending to the dam area;
a touch interlayer insulating film on the first bridge metal and the lower touch routing line;
a touch sensor metal electrically connected to the first bridge metal and on the touch interlayer insulating film; and
a second encapsulation layer on the touch sensor metal and on an inner side of the touch interlayer insulating film disposed in the dam area.

2. The display device of claim 1, further comprising an outer dam disposed in the dam area,
wherein the outer dam includes:
the lower touch routing line;
a touch buffer film covering the lower touch routing line in the dam area; and
the touch interlayer insulating film covering the touch buffer film in the dam area.

3. The display device of claim 2, wherein the touch interlayer insulating film included in the outer dam has a thickness on an upper surface greater than a thickness on a side surface.

4. The display device of claim 2 or 3, wherein the outer dam includes a first outer dam on an outer side of the second encapsulation layer, and a second outer dam on an outer side of the first outer dam.

5. The display device of any of claims 2-4, wherein a side surface of the outer dam contacts with the second encapsulation layer.

6. The display device of any preceding claim, further comprising:
an upper touch routing line electrically connected to the touch sensor metal and the lower touch routing line; and
a touch pad electrically connected to the lower touch routing line and disposed in the pad area.

7. The display device of claim 6, wherein the upper touch routing line is on the touch interlayer insulating film, and is electrically connected to the lower touch routing line through a contact hole of the touch interlayer insulating film.

8. The display device of any preceding claim, further comprising a second bridge metal on the touch interlayer insulating film, and at least partially overlapping with the first bridge metal.

9. The display device of any of claims 2-8, further comprising:
a first inner dam on the outer side of the first encapsulation layer; and
a second inner dam between the first inner dam and the outer dam,
wherein the first inner dam and the second inner dam overlap with the second encapsulation layer from a plan view.

10. The display device of claim 9, wherein a height of the first inner dam is greater than a height of the second inner dam.

11. The display device of any preceding claim, wherein the second encapsulation layer is an organic insulating film.

12. The display device of claim 11, wherein the second encapsulation layer includes one of acrylic resin, epoxy resin, polyimide, polyethylene, or siliconoxycarbon.

13. The display device of any preceding claim, wherein the second encapsulation layer is formed through an inkjet process.

14. The display device of any preceding claim, further comprising an emission layer disposed below the first encapsulation layer.
